# EUROPÄISCHE PATENTANMELDUNG

(11) **EP 4 512 633 A1**
(43) Veröffentlichungstag der Anmeldung: **26.02.2025**
(21) Anmeldenummer: 24175847.3
(22) Anmeldetag: 14.05.2024
(51) Int. Cl.: B44C 3/02, B44C 5/04

(54) **VERFAHREN ZUR HERSTELLUNG EINES WERKSTÜCKS MIT STRUKTURSCHICHT**

(30) Priorität: 24.08.2023 DE 102023208138
(71) Anmelder: Hymmen GmbH Maschinen- und Anlagenbau, 33613 Bielefeld (DE)
(72) Erfinder: PANKOKE, René, 33739 Bielefeld (DE)
(74) Vertreter: Prüfer & Partner mbB Patentanwälte · Rechtsanwälte

(57) **Zusammenfassung**

Es wird ein Verfahren zur Herstellung mindestens eines Werkstücks mit einer Strukturschicht auf einem Trägerelement (1) offenbart. Das Verfahren umfasst die folgenden Schritte:
- Schritt (S10): Bereitstellen des Trägerelements (1), das auf einer Trägerelementoberfläche (7) eine flüssige und härtbare Schicht (2) aufweist;
- Schritt (S12): Aufbringen eines Maskierungsmittels (3) auf die Schicht (2), derart, dass das Maskierungsmittel (3) an einer ersten Stelle (4) auf der Schicht (2) eine erste Schichtstärke aufweist und dass das Maskierungsmittel (3) an einer zweiten Stelle (5) auf der Schicht (2) eine zweite Schichtstärke aufweist, wobei die erste Schichtstärke größer als die zweite Schichtstärke ist;
- Schritt (S14): Aushärten der Schicht (2), wobei Material der Schicht (2) an der ersten Stelle (4) unterhalb des dort aufgebrachten Maskierungsmittels (3) weniger stark oder nicht aushärtet als Material der Schicht (2) an der zweiten Stelle (5) unterhalb des dort aufgebrachten Maskierungsmittels (3); und
- Schritt (S16): Entfernen von nicht ausgehärtetem Material der Schicht (2), so dass das gehärtete Material der Schicht (2) die Strukturschicht mit einem Höhenprofil auf dem Trägerelement (1) bildet.

Darüber hinaus wird eine Vorrichtung zur Durchführung des Verfahrens offenbart.

## Beschreibung

Die vorliegende Erfindung bezieht sich auf ein Verfahren zur Herstellung mindestens eines Werkstücks mit einer Strukturschicht auf einem Trägerelement sowie eine Vorrichtung zur Durchführung des Verfahrens.

Die Erstellung von Werkstücken mit Strukturschichten insbesondere zu dekorativen Zwecken ist bekannt. Beispielsweise werden Bauteile für die Fußboden- oder Möbelherstellung mit einem Holzdekor versehen, das neben der Holzoptik auch haptisch erfassbare Holzstrukturen aufweist. Dazu sind in der Vergangenheit unterschiedliche Ansätze entwickelt worden. Beispielsweise wird eine Holzstruktur mittels Prägewerkzeug (bspw. Prägewalze oder Prägeblech) in eine Kunststoffschicht geprägt, um die holztypischen Vertiefungen in der Schicht zu erhalten. Der Einsatz eines Prägewerkzeugs ist in der Regel wenig flexibel, da man in der Gestaltung der Struktur auf das auf dem Prägewerkzeug vorhandene Muster beschränkt ist.

Werkstücke mit Strukturschichten werden ferner in nachfolgenden Produktionsschritten weiterbearbeitet. Beispielsweise werden die Kanten der Schicht, welche später insbesondere als Sichtkanten vorliegen, mit einer Fase oder Rundung versehen. Dabei wird Material, insbesondere Material der Strukturschicht, abgetragen. Dies ist aufwändig, da damit mindestens ein zusätzlicher Arbeitsschritt verbunden ist.

Es ist daher Aufgabe der vorliegenden Erfindung, eine Alternative zu den oben genannten Verfahren zu nennen, um zumindest eins der oben genannten Probleme zu lösen.

Diese Aufgabe wird durch die Gegenstände der unabhängigen Ansprüche gelöst. Vorteilhafte Weiterbildungen sind Gegenstand der abhängigen Ansprüche.

Vorzugsweise ist ein Verfahren zur Herstellung mindestens eines Werkstücks mit einer Strukturschicht auf einem Trägerelement vorgesehen. Das Verfahren weist die folgenden Schritte auf:
- Schritt S10: Bereitstellen des Trägerelements, das auf einer Trägerelementoberfläche eine flüssige und härtbare Schicht aufweist;
- Schritt S12: Aufbringen eines Maskierungsmittels auf die Schicht, derart, dass das Maskierungsmittel an einer ersten Stelle auf der Schicht eine erste Schichtstärke aufweist und dass das Maskierungsmittel an einer zweiten Stelle auf der Schicht eine zweite Schichtstärke aufweist, wobei die erste Schichtstärke größer als die zweite Schichtstärke ist;
- Schritt S14: Aushärten der Schicht, wobei Material der Schicht an der ersten Stelle unterhalb des dort aufgebrachten Maskierungsmittels weniger stark oder nicht aushärtet als Material der Schicht an der zweiten Stelle unterhalb des dort aufgebrachten Maskierungsmittels; und
- Schritt S16: Entfernen von nicht ausgehärtetem Material der Schicht, so dass das gehärtete Material der Schicht die Strukturschicht mit einem Höhenprofil auf dem Trägerelement bildet.

Vorzugsweise ist das Werkstück oder das Trägerelement plattenförmig.

Vorzugsweise bildet die Strukturschicht damit eine Oberfläche auf dem Trägerelement, die gekennzeichnet ist durch ein Höhenprofil. D.h., dass sich zumindest entlang einer Richtung in einer Schnittansicht durch das so erzeugte Werkstück die Schichtstärke der Schicht auf dem Trägerelement ändert, wobei der Schnitt so geführt ist, dass sowohl Trägerelement als auch Schicht geschnitten sind.

Das Maskierungsmittel schützt die Schicht bzw. das Material der Schicht unter dem Maskierungsmittel während der Aushärtung davor, vollständig auszuhärten. Es ist auch denkbar, dass eine komplette Blockierung der Aushärtung an der ersten Stelle erfolgt und die Schicht flüssig oder zumindest in dem Zustand, den sie vor Schritt S14 hatte, bleibt.

Vorzugsweise weist das Höhenprofil an der ersten Stelle eine geringere Höhe auf als an der zweiten Stelle. Auf diese Weise ist es möglich, Strukturen in der Schicht auszubilden, die beispielsweise beliebigen Dekoren, wie Holz-, Stein- oder Fliesendekoren nachempfunden sind. Allgemein bedeutet eine geringere Höhe, dass an der ersten Stelle weniger Material der Schicht ausgehärtet wurde, so dass dieses nach Schritt S16 entfernt wurde und eine entsprechende Vertiefung in der Schicht zurückbleibt, also eine geringere Höhe des Höhenprofils als an der zweiten Stelle entsteht.

Vorzugsweise grenzen die erste Stelle und die zweite Stelle direkt aneinander. Erfolgt das Aufbringen des Maskierungsmittels in unterschiedlicher Schichtstärke auf direkt aneinander angrenzende Stellen, so kann während dem Aushärten in Schritt S14 erreicht werden, dass die angrenzenden Stellen unterschiedlich stark aushärten. Je nach der Auftragsmenge von Maskierungsmittel an diesen beiden Stellen und evtl. weiteren daran angrenzenden Stellen, kann erreicht werden, dass eine graduelle Aushärtung des Materials der Schicht darunter erreicht wird. Wird eine entsprechend feine Abstufung der Menge des aufgebrachten Maskierungsmittels zwischen den einzelnen Stellen vorgenommen, so kann auch eine von Stelle zu Stelle kontinuierlich veränderliche Aushärtung der Schicht erreicht werden. Ist bspw. die Schichtstärke an Maskierungsmittel an der ersten Stelle am größten und ist diese an der zweiten Stelle geringer und nimmt diese bei weiter angrenzenden Stellen weiter ab, so kann eine immer stärkere Aushärtung der Schicht darunter erreicht werden, angefangen mit der niedrigsten Aushärtung an der ersten Stelle. Ein Entfernen von nicht ausgehärtetem Material der Schicht führt dann zu einem entsprechend graduellen Höhenprofil.

Vorzugsweise befindet sich die erste Stelle oder die zweite Stelle an einem Rand der Schicht. Auf diese Weise kann das Höhenprofil auch am Rand der Schicht beeinflusst werden. Befindet sich die erste Stelle am Rand der Schicht und grenzt die zweite Stelle ausgehend vom Rand der Schicht zur Mitte der Schicht hin an die erste Stelle an, so kann eine vom Rand aus ansteigende Aushärtung der Schicht erreicht werden und letztlich nach dem Entfernen des nicht ausgehärteten Materials der Schicht ein Höhenprofil, das vom Rand in Richtung Mitte der Schicht ansteigt.

Vorzugsweise erstrecken sich die erste Stelle und die zweite Stelle entlang einer ersten, parallel zur Trägerelementoberfläche verlaufenden Richtung. Auf diese Weise kann erreicht werden, dass das Höhenprofil, das nach dem Entfernen des nicht ausgehärteten Materials der Schicht entsteht, entlang dieser Richtung verläuft. Ist beispielsweise eine Vertiefung an der ersten Stelle bzw. an der zweiten Stelle durch Entfernen des nicht ausgehärteten Materials der Schicht gebildet worden, so erstreckt sich diese entlang dieser Richtung. So kann beispielsweise ein Höhenprofil an anderen Konturen des Werkstücks orientiert werden. Die Richtung kann hierzu beispielsweise parallel zum Rand der Schicht oder des Trägerelements verlaufen.

Vorzugsweise erfolgt mit einem Trennwerkzeug eine Trennung des Trägerelements mit der darauf befindlichen Schicht entlang der ersten Richtung. Insbesondere bei der Fertigung großer Stückzahlen derartiger Werkstücke kann vorgesehen sein, dass ein großes Trägerelement mit der darauf befindlichen Schicht in kleinere Formate zurechtgeschnitten wird. Dazu wird beispielsweise mit einer Säge als Trennwerkzeug ein Schnitt durch das Trägerelement sowie durch die darauf befindliche Schicht durchgeführt, um das gewünschte Format zu erhalten. Der Schnitt erfolgt vorzugsweise nach dem Aushärten der Schicht gemäß Schritt S14. Er kann jedoch vor oder nach dem Entfernen von nicht ausgehärtetem Material der Schicht gemäß Schritt S16 durchgeführt werden.

Vorzugsweise ist das Höhenprofil als Fase oder Verrundung ausgeformt. Die Fase oder Verrundung verläuft bevorzugt entlang eines Randes der Schicht oder des Trägerelements. Auf diese Weise kann ein zusätzlich Bearbeitungsschritt, bei dem das Einbringen einer Fase oder Verrundung mittels Werkzeug durchgeführt wird, eingespart werden, denn die Fase oder Verrundung wird bereits mit dem Entfernen von nicht ausgehärtetem Material der Schicht gemäß Schritt S16 als Höhenprofil oder Teil des Höhenprofils gebildet.

Bevorzugt ist dabei folgendes Verfahren vorgesehen. Es wird eine Schnittrichtung bzw. Schnittline als die vorstehend beschriebene erste Richtung definiert, entlang derer ein Werkzeug eine Trennung des Werkstücks sowie der darauf befindlichen Schicht vornimmt. Parallel zu dieser Richtung wird Maskierungsmaterial auf die Schicht aufgebracht, so dass sich die erste Stelle und die zweite Stelle und ggf. die weiteren Stellen, auf die Maskierungsmaterial auf die Schicht aufgebracht wird, parallel zu der Richtung erstrecken, wobei vorzugsweise die erste Stelle direkt an den Bereich angrenzt, durch den das Werkzeug bei der Ausführung des Schnittes geführt wird. Dabei kann es sich beispielsweise um den Bereich auf der Schicht handeln, durch den ein Sägeblatt als Werkzeug geführt wird. Nach dem Aushärten der Schicht ist das Material der Schicht unter dem Maskierungsmaterial entsprechend weniger stark ausgehärtet. Nun kann der Schnitt zur Trennung des Werkstücks durchgeführt werden, wobei anschließend das Entfernen von nicht ausgehärtetem Material der Schicht durchgeführt werden (Schritt S16). Alternativ kann auch erst das Entfernen von nicht ausgehärtetem Material der Schicht durchgeführt werden (Schritt S16) und anschließend der Schnitt zur Trennung des Werkstücks durchgeführt werden. Nach dem Entfernen von nicht ausgehärtetem Material der Schicht bleibt angrenzend zur Schnittkante ein Höhenprofil zurück, das, wenn die Maskierung an der ersten und zweiten Stelle entsprechend durchgeführt wurde, insbesondere als Fase oder Verrundung parallel zur Schnittkante ausgeformt ist. Eine späteres Anbringen der Fase oder Verrundung in einem separaten Bearbeitungsschritt ist damit nicht nötig.

Vorzugsweise weist das Höhenprofil entlang einer zweiten Richtung, die senkrecht zu der ersten Richtung ist und die parallel zur Trägerelementoberfläche verläuft, unterschiedliche Höhen auf. Der Querschnitt des Werkstücks, der durch das Höhenprofil bestimmt ist, ändert sich damit in der Höhe entlang dieser zweiten Richtung. Vorzugsweise ändert sich der Querschnitt in der ersten Richtung nicht. Auf diese Weise können Vertiefungen bzw. ein Höhenprofil in der Schicht ausgebildet werden, die gefrästen Nuten, Fasen oder Kantenverrundungen oder ähnlichen Elementen entsprechen. Es ist jedoch nicht nötig tatsächlich Nuten in einem Nachbearbeitungsschritt einzubringen.

Vorzugsweise steigt das Höhenprofil entlang der zweiten Richtung, ausgehend von einer durch das Trennwerkzeug erzeugten Schnittkante an. Auf diese Weise wird ausgehend von der Schnittkante ein Höhenprofil erzeugt, das als Fase, Verrundung oder dergleichen ausgebildet sein kann. Auf diese Weise kann die mechanische Nachbearbeitung der Kanten des Werkstücks unterbleiben.

Vorzugsweise wird das Maskierungsmittel auf Teilflächen der Schicht aufgebracht, wobei zumindest eine dritte Stelle der Schicht von dem Maskierungsmittel unbedeckt bleibt. Diese Stelle liegt dann frei und wird während des Aushärtens (Schritt S14) nicht an der Aushärtung gehindert. Vorzugsweise härtet diese Stelle so aus, dass während des Entfernens von nicht ausgehärtetem Material der Schicht (Schritt S16) an dieser Stelle kein Material entfernt wird.

Vorzugsweise wird das Maskierungsmittel in Schritt S12 in flüssiger Form auf die Schicht aufgebracht. Auf diese Weise ist eine Dosierung einfach möglich.

Vorzugsweise wird das Maskierungsmittel in Schritt S12 als Tröpfchen, besonders bevorzugt mit einer digitalen Druckvorrichtung, auf die Schicht aufgebracht. Eine digitale Druckvorrichtung ermöglicht den flexiblen und zielgenauen Auftrag des Maskierungsmittels, wobei zudem auch eine entsprechende Dosierung des Maskierungsmittels möglich ist.

Vorzugsweise wird die Schicht vor Schritt S12 teilweise getrocknet oder gehärtet, um zu ermöglichen, dass das Maskierungsmittel von der Schicht getragen werden kann. Eine Trocknung kann beispielsweise durch Wärmezuführung an die Schicht erfolgen, so dass der Schicht Flüssigkeit bspw. mittels Verdampfung entzogen wird, so dass deren Viskosität, Oberflächenspannung und/oder Dichte entsprechend verändert wird, um das Maskierungsmittel tragen zu können. Eine Härtung um Viskosität, Oberflächenspannung und/oder Dichte entsprechend zu verändern kann auf die gleiche Weise wie die Härtung gemäß Schritt S14 erfolgen, wie sie insbesondere nachfolgend beschrieben wird. Jedoch wird die Trocknung oder Härtung vor Schritt S12 in jedem Fall so durchgeführt, dass die Schicht nicht komplett ausgehärtet ist, so dass in Schritt S16 ein Entfernen von Material der Schicht noch möglich ist.

Vorzugsweise umfasst das Aushärten in Schritt S14 ein Aushärten durch Strahlung, Wärmezufuhr und/oder Trocknung. Die Schicht ist bevorzugt als polymerisierbare Schicht ausgebildet, die durch Strahlung einer Aushärtungsvorrichtung polymerisiert werden kann. Hierfür kann insbesondere UV-Strahlung, IR-Strahlung oder Elektronenstrahlung verwendet werden. Bei Wärmezufuhr kann beispielsweise ein Lösungsmittel oder Flüssigkeit in der Schicht verdampfen und/oder bei Trocknung wird der Schicht Flüssigkeit entzogen.

Das Maskierungsmittel ist bevorzugt als digital oder analog verdruckbare Tinte ausgebildet, die lösemittelbasiert oder wasserbasiert ist. Alternativ kann das Maskierungsmittel auch Wasser sein.

Vorzugsweise erfolgt das Entfernen von nicht ausgehärtetem Material der Schicht in Schritt S16 mechanisch und/oder oder berührungslos. Bei mechanischem Entfernen kann dies durch ein Kontaktelement erfolgen. Das Kontaktelement kann insbesondere ein Bürstenelement, wie eine stehende oder rotierende Bürste, und/oder ein Hobelelement aufweisen, das in Kontakt mit der Schicht nicht ausgehärtetes Material der Schicht entfernt. Bei berührungslosem Entfernen kann insbesondere ein Fluidstrom aus einer Düse eingesetzt werden, der auf die Schicht gerichtet ist, und nicht ausgehärtetem Material der Schicht entfernt. Der Fluidstrom kann bevorzugt Festkörper wie Sand, Trockeneis oder dergleichen enthalten. Entferntes Material der Schicht wird bevorzugt mittels einer Absaugeinrichtung aufgesaugt. Die Absaugeinrichtung ist bevorzugt so platziert, dass das mittels Kontaktelement oder Fluidstrom entfernte Material der Schicht auf die Absaugeinrichtung zubewegt wird. Kontaktelement, Düse und/oder Absaugeinrichtung können Teil einer Entfernungsvorrichtung der weiter unten beschriebenen Vorrichtung sein.

Vorzugsweise umfasst Schritt S10, dass die Schicht auf das Trägerelement aufgebracht wird. Das Aufbringen der Schicht kann mittels einer digitalen Druckvorrichtung erfolgen oder auch mittels einem anderen Verfahren. Insbesondere kann ein Aufbringen der Schicht mittels analogem Druckverfahren erfolgen, bei dem eine Druckwalze oder eine Gießvorrichtung eingesetzt wird.

Alternativ oder zusätzlich umfasst Schritt S10, dass sich ein Basisdekor unterhalb der Schicht befindet oder aufgebracht wird, wobei das Basisdekor durch die Strukturschicht sichtbar ist. Bei dem Basisdekor kann es sich üblicherweise um ein Dekorbild handeln. Soll beispielsweise ein Holzdekor erzeugt werden, so ist als Basisdekor eine Holzdekor auf dem Werkstück vorhanden bzw. es wird darauf aufgebracht. Für das Aufbringen kann eine digitale oder analoge Druckvorrichtung eingesetzt werden. Die Strukturschicht selbst, also die ausgehärtete Schicht auf dem Trägerelement, die mit dem Höhenprofil versehen ist, ist bevorzugt so ausgebildet, dass sie zumindest teilweise transparent ist, so dass das Basisdekor erkannt werden kann und für einen Betrachter die Strukturschicht in Zusammenhang mit dem sichtbaren Basisdekor eine optische Einheit ergeben.

Nachfolgend wird eine Vorrichtung zur Durchführung des oben beschriebenen Verfahrens beschrieben. Dabei ist für einen Fachmann klar, dass die oben beschriebenen Ausprägungen des Verfahrens auch als entsprechende Ausgestaltungsmerkmale der Vorrichtung zu verstehen sind.

Vorzugsweise ist eine Vorrichtung zur Durchführung des oben beschriebenen Verfahrens vorgesehen. Die Vorrichtung weist die folgenden Elemente auf:
- eine Aufbringungsvorrichtung, die zur Aufbringung des Maskierungsmittels auf die Schicht ausgebildet ist;
- eine Aushärtungsvorrichtung, die zum Aushärten der Schicht ausgebildet ist; und
- eine Entfernungsvorrichtung, die dazu ausgebildet ist, nicht ausgehärtetes Material der Schicht zu entfernen, wobei
die Vorrichtung eine Steuervorrichtung aufweist, die dazu ausgebildet ist, die Aufbringungsvorrichtung, die Aushärtungsvorrichtung sowie die Entfernungsvorrichtung entsprechend der Schritte S12, S14 und S16 anzusteuern.

Vorzugsweise weist die Vorrichtung mindestens eines der folgenden Elemente auf:
- eine Vorbereitungsvorrichtung, die dazu ausgebildet ist, das Trägerelement bereitzustellen und insbesondere Schritt S10 wie oben beschrieben durchzuführen; und/oder
- eine Trennvorrichtung, die ein Trennwerkzeug aufweist und dazu ausgebildet ist, eine Trennung des Trägerelements mit der darauf befindlichen Schicht entlang der ersten Richtung durchzuführen.

Vorzugsweise weist die Vorrichtung eine Transportvorrichtung, besonders bevorzug mit einem Bandtransport auf, die dazu ausgebildet ist, das Trägerelement bzw. das Werkstück zu den entsprechenden Elementen zu transportieren.

Nachfolgend wird die Erfindung anhand bevorzugter Ausführungsbeispiele unter Zuhilfenahme der beigefügten Zeichnungen beschrieben.

Es zeigen:
- Fig. 1: ein Ablaufdiagram einer bevorzugten Ausführungsform des Verfahrens des Verfahrens,
- Fig. 2a-c: Herstellungsphasen eines Werkstücks nach einer ersten Ausführungsform des Verfahrens,
- Fig. 3a-c: Herstellungsphasen eines Werkstücks nach einer zweiten Ausführungsform des Verfahrens, und
- Fig. 4a-c: Herstellungsphasen eines Werkstücks nach einer dritten Ausführungsform.

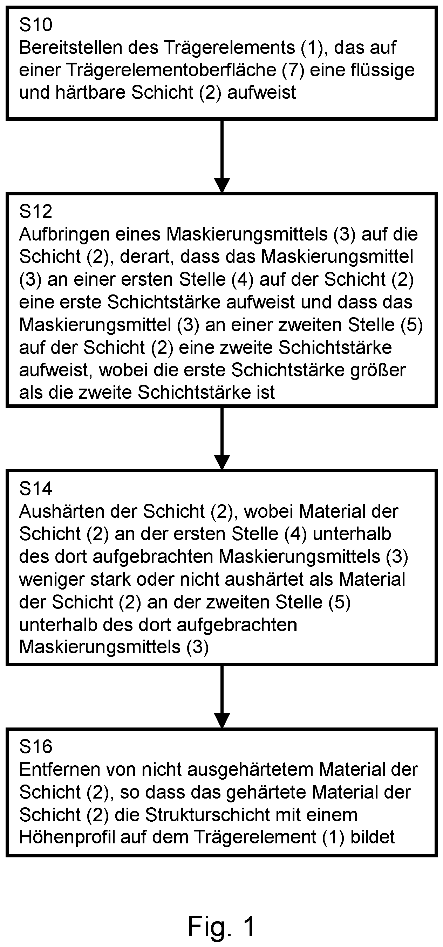

**Fig. 1** zeigt ein Ablaufdiagram einer bevorzugten Ausführungsform des Verfahrens.

Das gezeigte Verfahren dient zur Herstellung mindestens eines Werkstücks mit einer Strukturschicht auf einem Trägerelement und weist die folgenden Schritte auf:
- Schritt S10: Bereitstellen des Trägerelements, das auf einer Trägerelementoberfläche eine flüssige und härtbare Schicht aufweist;
- Schritt S12: Aufbringen eines Maskierungsmittels auf die Schicht, derart, dass das Maskierungsmittel an einer ersten Stelle auf der Schicht eine erste Schichtstärke aufweist und dass das Maskierungsmittel an mindestens einer zweiten Stelle auf der Schicht eine zweite aufweist, wobei die erste Schichtstärke größer als die zweite Schichtstärke ist;
- Schritt S14: Aushärten der Schicht, wobei Material der Schicht an der ersten Stelle unterhalb des dort aufgebrachten Maskierungsmittels weniger stark oder nicht aushärtet als Material der Schicht an der zweiten Stelle unterhalb des dort aufgebrachten Maskierungsmittels; und
- Schritt S16: Entfernen von nicht ausgehärtetem Material der Schicht, so dass das gehärtete Material der Schicht die Strukturschicht mit einem Höhenprofil auf dem Trägerelement bildet.

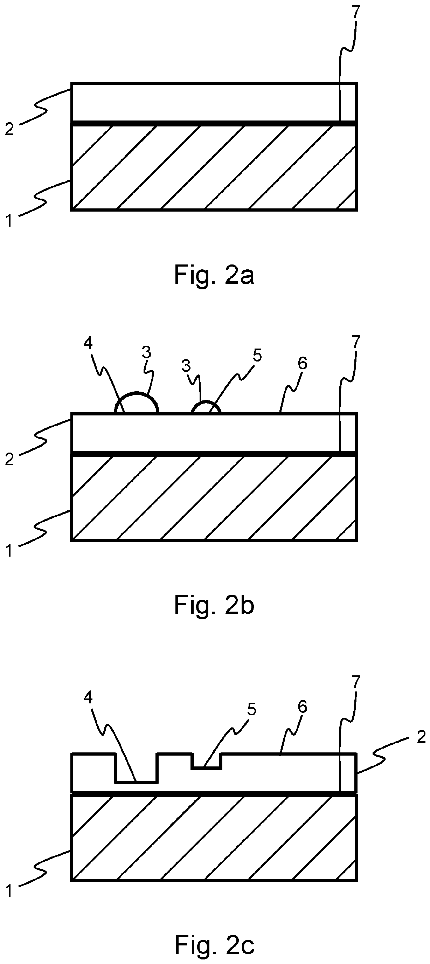

Die nachfolgend beschriebenen Herstellungsphasen eines Werkstücks gemäß der Figuren 2a-c, 3a-c und 4a-c nehmen auf die vorstehend beschriebenen Verfahrensschritte Bezug.

**Fig. 2a****-c** zeigen Herstellungsphasen eines Werkstücks nach einer ersten Ausführungsform des Verfahrens.

In Fig. 2a ist ein Werkstück im Schnitt gezeigt, das ein Trägerelement 1 und eine Schicht 2 auf einer Trägerelementoberfläche 7 aufweist. Auf der Trägerelementoberfläche 7 kann sich ein Basisdekor, wie ein Dekorbild befinden. Der Zustand des hier gezeigten Werkstücks entspricht dem am Ende von Schritt S10, wie er in Fig. 1 und in der allgemeinen Beschreibung erläutert wurde.

In Fig. 2b ist das Werkstück gezeigt, wobei auf die Schicht 2 nun an einer ersten Stelle 4 und an einer zweiten Stelle 5 ein Maskierungsmittel 3 aufgebracht wurde. Das Aufbringen des Maskierungsmittel 3 erfolgte dabei so, dass eine erste Schichtstärke des Maskierungsmittels 3 an der ersten Stelle 4 größer ist als eine Schichtstärke des Maskierungsmittels 3 an der zweiten Stelle 5. Eine dritte Stelle 6 der Schicht 2 ist nicht mit dem Maskierungsmittel 3 bedeckt worden. Diese liegt frei. Der in Fig. 2b gezeigte Zustand entspricht dem nach der Ausführung von Schritt S12.

Das Maskierungsmittel 3 ist dazu ausgebildet, bei dem nachfolgend durchzuführenden Aushärten der Schicht gemäß Schritt S14, die Wirkung des Aushärtens auf das Material der Schicht 2 unterhalb des Maskierungsmittels 3 an der ersten Stelle 4 und an der zweiten Stelle 5 abzuschwächen oder an der ersten Stelle 4, bei entsprechend gewählter Schichtstärke des Maskierungsmittels 3, ganz zu blockieren. Die Härtung gemäß Schritt S14 erfolgt dann beispielsweise durch Strahlung, wie UV-Strahlung, IR-Strahlung oder Elektronenstrahlung, aus einer Aushärtungsvorrichtung, wodurch die Schicht 2 an der Stelle 6 am stärksten aushärtet und an der Stelle 4 am wenigsten. Das Maskierungsmittel 3 wirkt hier wie eine Blockierung für den Strahlungseintrag oder zumindest abschwächend auf den Strahlungseintrag.

In Fig. 2c ist nun der Zustand des Werkstücks gezeigt, nachdem Schritt S16 durchgeführt wurde und somit nicht ausgehärtetes Material der Schicht 2 entfernt wurde. Das Entfernen kann, wie oben beschrieben, insbesondere mechanisch und/oder berührungslos erfolgen. An der ersten Stelle 4 wurde durch das mit größerer Schichtstärke aufgetragene Maskierungsmittel 3 eine stärkere Abschirmung der Schicht 2 erreicht, so dass hier nur eine geringe Aushärtung erfolgt ist und relativ viel Material entfernt werden konnte. Im Vergleich dazu wurde an der zweiten Stelle 5 einer weniger starke Abschirmung der Schicht 2 erreicht und damit auch deren Aushärtung nicht in demselben Ausmaß verhindert, so dass hier weniger unverfestigtes Material vorlag, das entfernt wurde. Die freiliegende dritte Stelle 6 der Schicht 2 ist hingegen vollständig ausgehärtet, so dass hier kein unverfestigtes Material vorlag und somit auch nicht entfernt werden konnte. Dies ist damit zu begründen, dass die Schicht 2 nach der Aushärtung S14 so auf das Entfernen gemäß Schritt S16 abgestimmt ist, dass gehärtetes Material der Schicht 2 nicht entfernt wird. Im Ergebnis sind somit an den Stellen 4 und 5 Vertiefungen vorhanden, wobei die erste Stelle 4 die größere Vertiefung aufweist, da hier mehr unverfestigtes Material entfernt wurde.

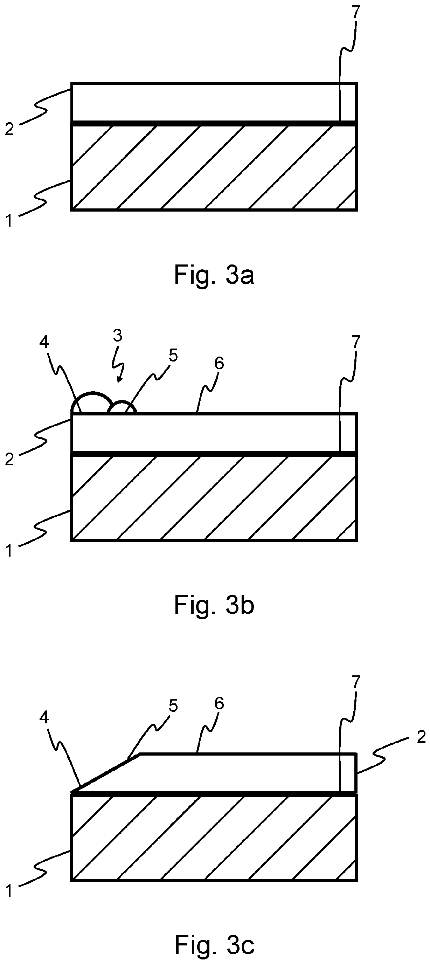

**Fig. 3a****-c** zeigen Herstellungsphasen eines Werkstücks nach einer zweiten Ausführungsform des Verfahrens.

In Fig. 3a ist ein Werkstück im Schnitt gezeigt, das ein Trägerelement 1 und eine Schicht 2 auf einer Trägerelementoberfläche 7 aufweist. Auf der Trägerelementoberfläche 7 kann sich ein Basisdekor, wie ein Dekorbild befinden. Der Zustand des hier gezeigten Werkstücks entspricht dem am Ende von Schritt S10, wie er in Fig. 1 und in der allgemeinen Beschreibung erläutert wurde.

Im Wesentlichen sind hier dieselben Zustände wie in den Figuren 2a-c gezeigt. Im Unterschied dazu wurde aber Schritt S12, nämlich das Aufbringen des Maskierungsmittels 3, so durchgeführt, dass nun die erste Stelle 4 an den linken Rand der Schicht 2 angrenzt und die zweite Stelle 5 rechts davon an die erste Stelle 4 angrenzt. Dies ist in Fig. 3b gezeigt. Dadurch wird erreicht, dass das Material der Schicht 2 unter dem Maskierungsmittel 3 an der ersten Stelle 4 weniger stark aushärtet als das Material der Schicht 2 unter dem Maskierungsmittel 3 an der zweiten Stelle 5. An den Stellen 4 und 5 ergibt sich von links nach rechts eine stetig steigende Wirkung der Aushärtung S14 bis schließlich entsprechend der freiliegenden dritten Stelle 6 die gesamte Schicht 2 aushärtet.

Wird nun gemäß Schritt S16 das nicht ausgehärtete Material der Schicht 2 entfernt, verbleibt ein Höhenprofil das im dargestellten Schnitt in Fig. 3c von links nach rechts bis zur maximalen Höhe der Schicht 2 ansteigt. Wird das Maskierungsmittel 3 so aufgebracht, dass sich die Stellen 4 und 5 parallel zu der Kante bzw. dem Rand der Schicht 2 erstrecken, d.h. in der Zeichnung der Fig. 3b senkrecht zur Zeichenebene, kann in diesem Fall der linke Rand der Schicht 2 und damit die entsprechende Kante des Werkstücks mit einer Fase versehen werden.

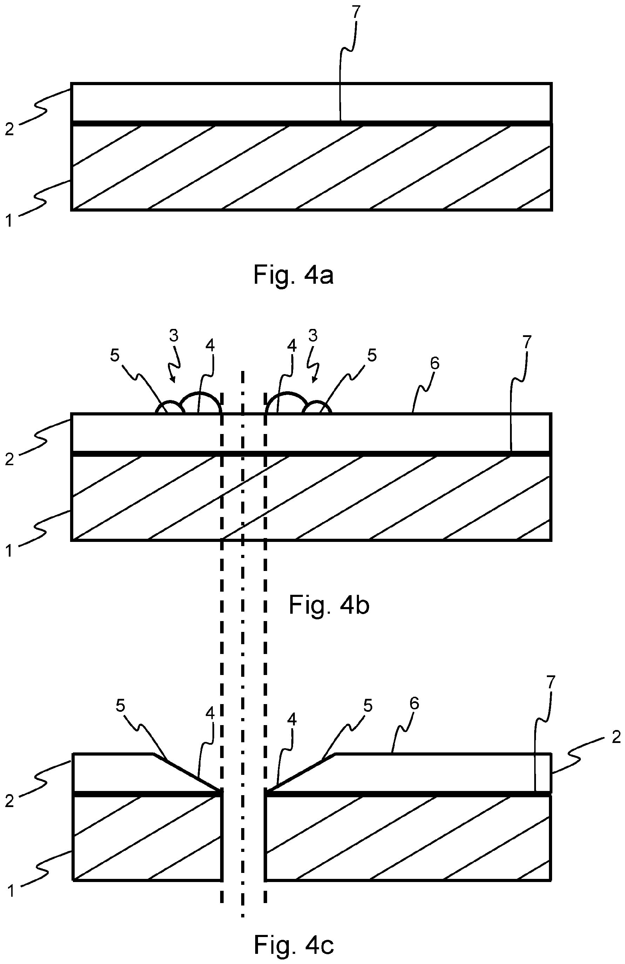

**Fig. 4a****-c** zeigen Herstellungsphasen eines Werkstücks nach einer dritten Ausführungsform des Verfahrens.

In Fig. 4a ist ein Werkstück im Schnitt gezeigt, das ein Trägerelement 1 und eine Schicht 2 auf einer Trägerelementoberfläche 7 aufweist. Auf der Trägerelementoberfläche 7 kann sich ein Basisdekor, wie ein Dekorbild befinden. Der Zustand des hier gezeigten Werkstücks entspricht dem am Ende von Schritt S10, wie er in Fig. 1 und in der allgemeinen Beschreibung erläutert wurde.

Das Aufbringen des Maskierungsmittels gemäß Schritt S12 erfolgte hier, wie in Fig. 4b gezeigt, nicht am Rand der Schicht 2, wie es in Fig. 3b gezeigt wurde. Hier wurde vielmehr ein Aufbringen des Maskierungsmittels 3 gemäß Schritt S12 vorgenommen, so dass eine erste Stelle 4 vorliegt, die eine größere Schichtstärke an Maskierungsmittel 3 als eine daran angrenzende zweite Stelle 5 aufweist. Zudem erfolgte der Auftrag so, dass auf dem Werkstück eine weitere Konfiguration mit einer ersten Stelle 4 und einer zweiten Stelle 5 vorliegt. Dabei wurde die Anordnung von erster und zweiter Stelle 4, 5 an der in der Zeichnung senkrecht eingezeichneten strichpunktierten Linie gespiegelt, so dass zwischen beiden Konfigurationen von erster und zweiter Stelle 4, 5 der Bereich vorhanden ist, der durch die beiden gestrichelten senkrechten Linien markiert ist. Dieser Bereich stellt den Bereich dar, in dem anschließend ein Trennwerkzeug geführt wird. Die jeweiligen ersten Stellen 4 grenzen dabei direkt an diesen Bereich an. Die Stellen 4 und 5 verlaufen dabei senkrecht zur Zeichenebene und damit parallel zu der ersten Richtung in der das Trennwerkzeug geführt wird.

In Fig. 4c ist nun der Zustand dargestellt, nachdem das Härten der Schicht 2 gemäß Schritt S14 sowie das Entfernen von nicht ausgehärtetem Material der Schicht 2 gemäß Schritt S16 durchgeführt wurde. Zudem wurde mittels eines Trennwerkzeuges, wie einer Säge, eine Trennung des Werkstücks durchgeführt, so dass sowohl Material des Trägerelements 1 als auch Material der Schicht 2, die sich im durch die gestrichelten Linien gekennzeichneten Bereich befanden, entfernt wurde. Rechts und links dieses Bereichs sind nun zwei separate Werkstücke zu sehen.

Dabei wurde, durch die entsprechende Verteilung der Schichtstärken von Maskierungsmittel 3 an den Stellen 4 und 5 erreicht, dass das Material der Schicht 2 darunter entsprechend an der Aushärtung gehindert wird, wodurch nach dem Schritt S16 ein Höhenprofil entsprechend der gezeigten Fasen auf der Schicht 2 angrenzend zu dem mit den gestrichelten Linien gekennzeichneten Bereich gebildet wird.

Dadurch wird ermöglicht, dass ein weiterer Bearbeitungsschritt zur nachträglichen Erzeugung der Fasen eingespart werden kann, da diese bereits als Höhenprofil erzeugt wurden. Die erzeugten Fasen verlaufen dabei von der jeweiligen Schnittkante, also dem Bereich, der durch die gestrichelten Linien gekennzeichnet ist, nach links bzw. rechts in einer zweiten Richtung in der Höhe ansteigend. Die zweite Richtung verläuft dabei in der Zeichenebene senkrecht zu der ersten Richtung und parallel zu der Trägerelementoberfläche 7.

### Bezugszeichenliste

- 1: Trägerelement
- 2: Schicht
- 3: Maskierungsmittel
- 4: erste Stelle der Schicht
- 5: zweite Stelle der Schicht
- 6: dritte Stelle der Schicht
- 7: Trägerelementoberfläche
- S10, S12, S14, S16:: Verfahrensschritte

## Patentansprüche

1. Verfahren zur Herstellung mindestens eines Werkstücks mit einer Strukturschicht auf einem Trägerelement (1) mit den Schritten:
- Schritt (S10): Bereitstellen des Trägerelements (1), das auf einer Trägerelementoberfläche (7) eine flüssige und härtbare Schicht (2) aufweist;
- Schritt (S12): Aufbringen eines Maskierungsmittels (3) auf die Schicht (2), derart, dass das Maskierungsmittel (3) an einer ersten Stelle (4) auf der Schicht (2) eine erste Schichtstärke aufweist und dass das Maskierungsmittel (3) an einer zweiten Stelle (5) auf der Schicht (2) eine zweite Schichtstärke aufweist, wobei die erste Schichtstärke größer als die zweite Schichtstärke ist;
- Schritt (S14): Aushärten der Schicht (2), wobei Material der Schicht (2) an der ersten Stelle (4) unterhalb des dort aufgebrachten Maskierungsmittels (3) weniger stark oder nicht aushärtet als Material der Schicht (2) an der zweiten Stelle (5) unterhalb des dort aufgebrachten Maskierungsmittels (3); und
- Schritt (S16): Entfernen von nicht ausgehärtetem Material der Schicht (2), so dass das gehärtete Material der Schicht (2) die Strukturschicht mit einem Höhenprofil auf dem Trägerelement (1) bildet.

2. Verfahren nach Anspruch 1, wobei
das Höhenprofil an der ersten Stelle (4) eine geringere Höhe aufweist als an der zweiten Stelle (5) und/oder
die erste Stelle (4) und die zweite Stelle (5) direkt aneinandergrenzenund/oder
sich die erste Stelle (4) oder die zweite Stelle (5) an einem Rand der Schicht (2) befindet.

3. Verfahren nach einem der vorstehenden Ansprüche, wobei
sich die erste Stelle (4) und die zweite Stelle (5) entlang einer ersten, parallel zur Trägerelementoberfläche (7) verlaufenden Richtung erstrecken, wobei
insbesondere mit einem Trennwerkzeug eine Trennung des Trägerelements (1) mit der darauf befindlichen Schicht (2) entlang der ersten Richtung erfolgt.

4. Verfahren nach einem der vorstehenden Ansprüche, wobei
das Höhenprofil als Fase oder Verrundung ausgeformt ist.

5. Verfahren nach Anspruch 3 oder 4, wobei
das Höhenprofil entlang einer zweiten Richtung, die senkrecht zu der ersten Richtung ist und die parallel zur Trägerelementoberfläche (7) verläuft, unterschiedliche Höhen aufweist.

6. Verfahren nach Anspruch 3 in Kombination mit Anspruch 5, wobei
das Höhenprofil entlang der zweiten Richtung, ausgehend von einer durch das Trennwerkzeug erzeugten Schnittkante ansteigt.

7. Verfahren nach einem der vorstehenden Ansprüche, wobei
das Maskierungsmittel (3) auf Teilflächen der Schicht (2) aufgebracht wird und zumindest eine dritte Stelle (6) der Schicht (2) von dem Maskierungsmittel (3) unbedeckt bleibt.

8. Verfahren nach einem der vorstehenden Ansprüche, wobei
das Maskierungsmittel (3) in Schritt (S12) in flüssiger Form auf die Schicht (2) aufgebracht wird.

9. Verfahren nach einem der vorstehenden Ansprüche, wobei
das Maskierungsmittel (3) in Schritt (S12) als Tröpfchen mit einer digitalen Druckvorrichtung auf die Schicht (2) aufgebracht wird.

10. Verfahren nach einem der vorstehenden Ansprüche, wobei
die Schicht (2) vor Schritt (S12) teilweise getrocknet oder gehärtet wird, um zu ermöglichen, dass das Maskierungsmittel (3) von der Schicht (2) getragen werden kann.

11. Verfahren nach einem der vorstehenden Ansprüche, wobei
das Aushärten in Schritt (S14) ein Aushärten durch Strahlung, Wärmezufuhr und/oder Trocknung umfasst.

12. Verfahren nach einem der vorstehenden Ansprüche, wobei
das Entfernen von nicht ausgehärtetem Material der Schicht (2) in Schritt (S16) mechanisch und/oder oder berührungslos erfolgt.

13. Verfahren nach einem der vorstehenden Ansprüche, wobei
Schritt (S10) umfasst, dass die Schicht (2) auf das Trägerelement (1) aufgebracht wird und/oder, dass sich ein Basisdekor unterhalb der Schicht (2) befindet oder aufgebracht wird, wobei das Basisdekor durch die Strukturschicht sichtbar ist.

14. Vorrichtung zur Durchführung des Verfahrens nach einem der vorstehenden Ansprüche, mit folgenden Elementen:
- eine Aufbringungsvorrichtung, die zur Aufbringung des Maskierungsmittels (3) auf die Schicht (2) ausgebildet ist;
- eine Aushärtungsvorrichtung, die zum Aushärten der Schicht (2) ausgebildet ist; und
- eine Entfernungsvorrichtung, die dazu ausgebildet ist, nicht ausgehärtetes Material der Schicht (2) zu entfernen, wobei
die Vorrichtung eine Steuervorrichtung aufweist, die dazu ausgebildet ist, die Aufbringungsvorrichtung, die Aushärtungsvorrichtung sowie die Entfernungsvorrichtung entsprechend der Schritte (S12, S14, S16) anzusteuern.

15. Vorrichtung nach Anspruch 14, mit mindestens einem der folgenden Elemente:
- eine Vorbereitungsvorrichtung, die dazu ausgebildet ist, das Trägerelement (1) bereitzustellen; und/oder
- eine Trennvorrichtung, die ein Trennwerkzeug aufweist und dazu ausgebildet ist, eine Trennung des Trägerelements (1) mit der darauf befindlichen Schicht (2) entlang der ersten Richtung durchzuführen.
